# EUROPÄISCHE PATENTSCHRIFT

(11) **EP 2 777 061 B1**
(45) Veröffentlichungstag und Bekanntmachung des Hinweises auf die Patenterteilung: **12.12.2018**
(21) Anmeldenummer: 12794175.5
(22) Anmeldetag: 26.10.2012
(51) Int. Cl.: H01J 37/34, C23C 14/34

(54) **HIPIMS-SCHICHTEN**
HIPIMS-LAYERS
COUCHES HIPIMS

(30) Priorität: 09.11.2011 DE 102011117994
(43) Veröffentlichungstag der Anmeldung: 17.09.2014
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT); LECHTHALER, Markus, 39100 Bozen (IT)
(74) Vertreter: Kempkens, Anke
(86) Internationale Anmeldenummer: PCT/EP2012/004498
(87) Internationale Veröffentlichungsnummer: WO 2013/068080

(56) Entgegenhaltungen:
- DE-B3-102008 028 140
- DE-U1-202010 001 497
- LIN J ET AL: "Ion energy and mass distributions of the plasma during modulated pulse power magnetron sputtering", SURFACE AND COATINGS TECHNOLOGY, ELSEVIER, AMSTERDAM, NL, Bd. 203, Nr. 24, 15. September 2009 (2009-09-15), Seiten 3676-3685, XP026284332, ISSN: 0257-8972, DOI: 10.1016/J.SURFCOAT.2009.05.048 [gefunden am 2009-06-10]
- EHIASARIAN A ET AL: "Influence of high power impulse magnetron sputtering plasma ionization on the microstructure of TiN thin films", JOURNAL OF APPLIED PHYSICS, AMERICAN INSTITUTE OF PHYSICS. NEW YORK, US, Bd. 109, Nr. 10, 23. Mai 2011 (2011-05-23) , Seiten 104314-104314, XP012146923, ISSN: 0021-8979, DOI: 10.1063/1.3579443

## Beschreibung

Die vorliegende Erfindung bezieht sich auf Hartstoffschichten, welche mittels physikalischer Beschichtung aus der Gasphase (PVD = Physical Vapor Deposition) und zwar dem Magnetron unterstützten Zerstäuben (MS = Magnetron Sputtering) auf Werkstücke abgeschieden werden.

Zwei wesentliche Prozessvarianten des Magnetron Sputterns sind das klassische DC-MS und das HIPIMS Verfahren.

Beim HIPIMS wird dem das Zerstäubungsmaterial liefernde Target eine sehr hohe Entladungsstromdichte aufgezwungen, so dass im Plasma eine hohe Elektronendichte generiert wird und die zerstäubten Teilchen zu einem hohen Grad ionisiert werden. Dabei kommen Leistungsdichten zwischen 250W/cm² und 2000W/cm² zum Einsatz und an den die Leistung liefernden Generator sind somit besondere Anforderungen gestellt. Insbesondere ist es nicht möglich dauerhaft eine solche Leistung auf das Target einwirken zu lassen, da dieses überhitzen und somit Schaden nehmen würde. Die Leistung muss daher gepulst werden. Innerhalb des Leistungspulses kommt es zu den sehr hohen, gewünschten Entladungsdichten und das Target erhitzt sich und während der Pulspause kann das Target wieder abkühlen. Pulsdauer und Pulspause müssen so aufeinander abgestimmt sein, dass die mittlere auf das Target eingebrachte Leistung nicht einen Schwellenwert übersteigt. Für HIPIMS werden daher Generatoren benötigt, welche in der Lage sind gepulst sehr hohe Leistungen abzugeben.

Meist kommen bei HIPIMS daher spezielle Generatoren zum Einsatz, die auf dem Prinzip der Entladung von Kondensatoren beruhen, was zu einem Entladestrom führt der sich während des Pulses verändert. Ein kontrollierter Prozess betreffend des Strom-Spannungs Verlaufes ist auf diese Weise nicht zu erzielen. Gemäss einem anderen Ansatz wird das Plasma zunächst vorionisiert um dann im Rahmen des hohen Leistungspulses die Pulsdauer verlängern zu können. Der Entladestrom wird dabei durch Modulation der angelegten Spannung gesteuert. Auf diese Weise können Pulse bis zu 4ms aufrechterhalten bleiben.

Völlig anders sieht die Situation aus, wenn mit einer niedrigen Leistungsdichte zerstäubt wird, also beispielsweise zwischen 5W/cm² und 50W/cm². In diesem Fall kann das Target dauerhaft mit Leistung beaufschlagt werden. Es können einfache Generatoren zum Einsatz kommen, da weder hohe Leistungen abgegeben werden müssen noch muss die Leistungsabgabe gepulst sein. In einem solchen Fall handelt es sich um das klassische DC-MS.

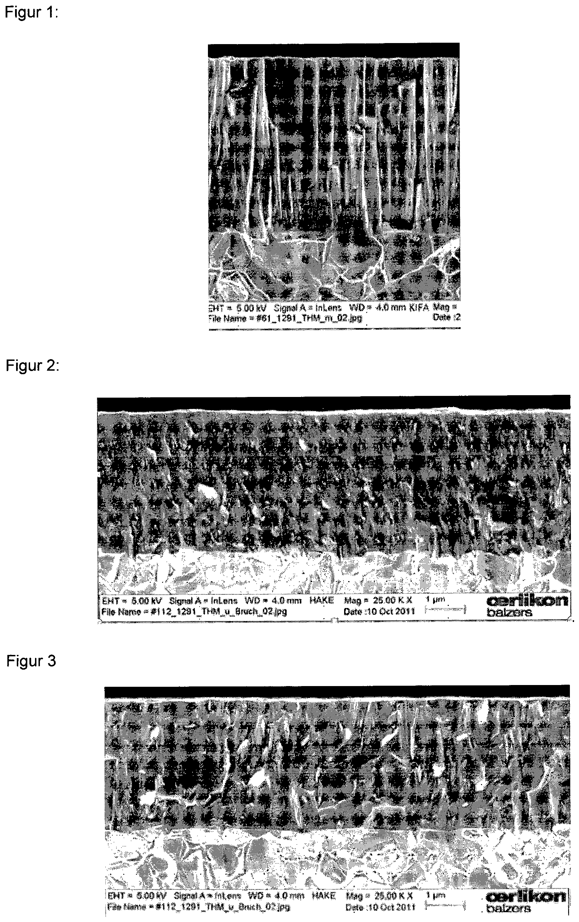

Vergleicht man HIPIMS-Schichten mit DC-MS Schichten so fallen grosse strukturelle Unterschiede auf. Am Beispiel von TiAIN Beschichtungen wachsen diese bei DC-MS im Wesentlichen in einer kolumnaren Struktur auf (sieh Figur 1). Beim HIPIMS Verfahren dagegen kann im Wesentlichen ohne den Einbau von Arbeitsgasionen in die Schicht eine feine Schichtstruktur durch die Ionisation des verdampften Metalls erzielt werden, denn im Falle eines an das Substrat angelegten negativen Bias werden die ionisierten Metallatome selbst auf das Substrat hin beschleunigt.. Vorteilhaft kommt dabei hinzu, dass bei HIPIMS-Schichten ein negativer Substratbias als Folge des hohen lonenanteils im zerstäubten Material zu einer starken Verdichtung der Schichten führt.

Die feinen HIPIMS-Schichten sind zwar härter und dichter als die grob-kolumnaren DC-MS-Schichten, zeigen aber auch Nachteile betreffend der Schichthaftung und der mechanischen Eigenschaften. Solche feinen HIPIMS-Schichten zeigen zwar im Vergleich zu den DC-MS Schichten ein verbessertes Verschleissverhalten, was eine längere Standzeit zur Folge hat. Nachteilig ist allerdings, dass sich die Abnutzung, d.h. das Ende der Lebensdauer der Schicht nicht ankündigt, sondern, vermutlich aufgrund der mechanischen Eigenschaften sehr rasch in Erscheinung tritt, beispielsweise in Form einer Abplatzung. Dem Anwender fällt es somit sehr schwer abzuschätzen, wann die beschichteten Werkzeuge auszuwechseln sind.

Der Erfindung liegt daher die Aufgabe zugrunde, Schichten zu offenbaren welche die für die HIPIMS-Technologie typische Härten aufweisen, deren Abnutzung sich aber in der Anwendung beispielsweise durch eine mit der Zeit auftretende geringere Bearbeitungseffizienz dem Anwender ankündigen, so dass dieser die Möglichkeit hat, die entsprechenden Werkzeuge auszuwechseln.

Wie oben geschildert sind derzeit HIPIMS-Generatoren bekannt, mit welchen eine Pulsdauer von maximal bis zu 4ms ermöglicht wird. Aufgrund eines neuen Verfahrens zur Bereitstellung von Pulsen hoher Leistung ist es aber nun ohne weiteres möglich Pulsdauern von 25ms und mehr zu realisieren. Zum Beispiel offenbart DE 20 2010 001 497 U1 ein Beschichtungsvorrichtung mit einer HIPIMS-Leistungsquelle wobei mehrere Teilkathoden sequentiell betrieben werden können.

Bei dem Verfahren wird so vorgegangen, dass eine PVD-Zerstäubungskathode, die eine erste Teilkathode und eine zweite Teilkathode umfasst betrieben wird, wobei für die Teilkathoden eine maximale mittlere Leistungsbeaufschlagung vorgegeben ist und wobei die Dauer der Leistungspulsintervalle vorgegeben werden und das Verfahren folgende Schritte umfasst
a) Bereitstellen eines Generators mit vorgegebener vorzugsweise zumindest nach Anschalten und nach Ablauf eines Leistungsaufbauintervalls konstanter Leistungsabgabe
b) Anschalten des Generators
c) Anschluss der ersten Teilkathode an den Generator, so dass die erste Teilkathode mit Leistung vom Generator beaufschlagt wird
d) Trennung des Generators von der ersten Teilkathode nach Ablauf eines vorgegebenen der ersten Teilkathode entsprechenden ersten Leistungspulsintervalls
e) Anschluss der zweiten Teilkathode an den Generator so dass die zweite Teilkathode mit Leistung vom Generator beaufschlagt wird
f) Trennung des Generators von der zweiten Teilkathode nach Ablauf eines vorgegebenen der zweiten Teilkathode entsprechenden zweiten Leistungspulsintervalls
wobei das erste Leistungspulsintervall zeitlich vor dem zweiten Leistungspulsintervall beginnt und das erste Leistungspulsintervall zeitlich vor dem zweiten Leistungspulsintervall endet, und wobei die Schritte d) und e) so ausgeführt werden dass sich erstes Leistungspulsintervall und zweites Leistungspulsintervall zeitlich überlappen und alle Leistungspulsintervalle zusammen eine erste Gruppe bilden, so dass die Leistungsabgabe vom Generator durchgehend ohne Unterbrechung vom Anfang des ersten Leistungspulsintervalls bis zum Ende des zweiten Leistungspulsintervalls bestehen bleibt und es nicht zu einem zweiten Leistungsaufbauintervall kommt.

In der Anwendung dieses Verfahrens haben die Erfinder zu ihrem Erstaunen festgestellt, dass Werkzeuge, welche mit HIPIMS-Schichten die mit einer Pulsdauer von 5ms oder mehr beschichtet wurden gegen Ende der Lebensdauer des beschichteten Werkzeugs ein signifikant anderes Verhalten zeigen als Werkzeuge welche mit HIPIMS-Schichten die mit kürzeren Pulsdauern beschichtet wurden. Interessanterweise zeigen SEM-Bilder von Bruchkanten der mit den langen Pulsen aufgebrachten Schichten eine gröber ausgeprägte Morphologie, wie dies in Figur 3 deutlich sichtbar ist. Dabei kann dieser Unterschied in der Schichtmorphologie rein durch die Variation der Pulslänge erzielt werden ohne weitere Einflussparameter zu verändern.

Die mit einer Pulsdauer von 5ms oder mehr abgeschiedenen erfindungsgemässen Schichten weisen im Vergleich zu den mit kurzen Pulsen aufgebrachten Schichten ein erhöhtes E- Modul sowie eine grössere Härte auf.

Beispielsweise wurden von den Erfindern TiAIN-Schichten mittels des HIPIMS-Verfahrens einerseits mit einer Pulslänge von 250µs und andererseits mit einer Pulslänge von 25000 µs abgeschieden. Die mit Pulslänge 250µs abgeschiedenen Schichten zeigten ein E-Modul von ca. 425GPa und hatten eine Härte von 2900HV während die mit Pulslänge 25000µs abgeschiedenen Schichten ein E-Modul von 475GPa zeigten und eine Härte hatten von mehr als 3100HV.

Da sich mit dem oben geschilderten Verfahren der Bereitstellung von Leistungspulsen in sehr einfacher Weise die Pulslänge einstellen und auch variieren lässt, ist es möglich, innerhalb einer Beschichtung ein Schichtsystem aufzubauen, in welchem sich HIPIMS-Schichten mit einer feineren und einer gröberen Morphologie abwechseln. Dies wird in einfacher Weise dadurch realisiert, dass zum Abscheiden abwechselnd eine kurze und eine lange Pulsdauer gewählt wird. Da für beide Abscheidungsarten in etwa dieselben Schichtspannungen gemessen wurden, wird ein solches Wechselschichtsystem erwartungsgemäss sehr gute Eigenschaften hinsichtlich Verschleissverminderung aufweisen. Das Wechselschichtsystem kann dabei abrupte Übergänge zeigen so dass sich regelrechte Grenzflächen zwischen feinkörniger Schicht und grobkörniger Schicht bilden. Es ist aber auch möglich einen oder mehrere graduelle Übergänge zu realisieren, indem die Pulsdauer nicht abrupt sondern kontinuierlich variiert wird.

Es wird darauf hingewiesen, dass im selben Beschichtungsgang natürlich auch die Höhe des Leistungspulses variiert werden kann. Insbesondere kann zeitweise eine so geringe Pulshöhe gewählt werden, dass sich Schichtbereiche mit dem für DC-MS typischen kolumnaren Wachstum ergeben. Es ist auf diese Weise auch ein Wechselschichtsystem aus HIPIMS-Schichten und DC-MS realisierbar, was aufgrund der unterschiedlichen Schichtspannungen zur Stabilität des Schichtsystems beitragen kann.

## Patentansprüche

1. Verfahren zum Abscheiden von PVD-Schichtsystemen aus der Gasphase mittels Zerstäuben auf zumindest einem Substrat, wobei das Schichtsystem zumindest eine erste und eine zweite HIPIMS-Schicht umfasst, welche mittels eines HIPIMS-Verfahrens abgeschieden werden, welches es erlaubt zumindest zwei Teilkathoden zu betreiben dergestalt, dass für die Abscheidung von HIPIMS-Schichten Leitungsdichten von 250W/ cm² oder mehr und Pulslängen mit Pulsdauern von 5ms oder mehr verwendet werden währenddessen am Substrat ein Substratbias anliegt, **dadurch gekennzeichnet, dass** die erste oder die zweite HIPIMS-Schicht in einem Schritt des HIPIMS-Verfahrens abgeschieden wird, bei dem eine Leistungsdichte von zumindest 250W/cm2 angewendet wird, wobei eine Pulslänge mit zumindest 5ms Dauer zum Einsatz kommt währenddessen am Substrat ein Substratbias anliegt, und für die Abscheidung der anderen ggf. der zweiten oder der ersten HIPIMS-Schicht eine Pulslänge mit einer kürzerer Pulsdauer angewendet wird dergestalt, dass sich die resultierte Morphologie der ersten HIPIMS-Schicht von der Morphologie der zweiten HIPIMS-Schicht unterscheidet und die Morphologie der bei einer längeren Pulsdauer abgeschiedenen HIPIMS-Schicht gröbere Körner als die Morphologie der bei einer kürzeren Pulsdauer abgeschiedenen HIPIMS-Schicht aufweist.

2. Verfahren nach einem der vorangehenden Ansprüche, **dadurch gekennzeichnet, dass** das Schichtsystem mehr als zwei HIPIMS-Schichten umfasst und während der Abscheidung der HIPIMS-Schichten abwechselnd eine kürzere und eine längere Pulsdauer angewendet wird.

3. Verfahren nach einem der vorangehenden Ansprüche, **dadurch gekennzeichnet, dass** die Pulslänge zumindest einmal kontinuierlich variiert wird.

4. Verfahren nach einem der vorangehenden Ansprüche, **dadurch gekennzeichnet, dass** die Höhe des Leistungspulses variiert wird.

5. Verfahren nach Anspruch 4, **dadurch gekennzeichnet, dass** zeitweise eine so geringe Höhe des Leistungspulses gewählt wird, dass sich Schichtbereiche mit einem für DC-MS typischen kolumnaren Wachstum ergeben.

6. Verfahren nach einem der vorangehenden Ansprüche, **dadurch gekennzeichnet, dass** die Leistungsdichte : 2000W/cm² nicht übersteigt.

7. Verfahren nach einem der vorangehenden Ansprüche 3 bis 6, **dadurch gekennzeichnet, dass** die zumindest eine kontinuierliche Variation der Pulslange durchgeführt wird dergestalt, dass der Übergang zwischen den Schichten unterschiedlicher Morphologie ein gradueller Übergang ist.

## Claims

1. Method for depositing PVD layer systems by vapor deposition by means of sputtering on at least one substrate, wherein the layer system comprises at least a first and a second HIPIMS layer which are deposited by means of a HiPIMS method which allows to operate at least two partial cathodes in such a way that for the deposition of HiPIMS layers power densities of 250W/cm² or more and impulse lengths having an impulse duration of 5ms or more are used, whilst on the substrate a substrate bias is applied **characterized in that** the first or the second HiPIMS layer is deposited in one step of the HiPIMS method in which a power density of at least 250W/cm² is used, wherein an impulse length with a duration of at least 5ms is used, whilst on the substrate a substrate bias is applied, and for the deposition of the other HIPIMS layer, if applicable of the second or the first HIPIMS layer, an impulse length with a shorter impulse duration is used in such a way that the resulting morphology of the first HiPIMS layer differs from the morphology of the second HIPIMS layer and the morphology of the HIPIMS layer deposited with a longer impulse duration has coarser particles than the morphology of the HIPIMS layer deposited with a shorter impulse duration.

2. Method according to one of the preceding claims, **characterized in that** the layer system comprises more than two HIPIMS layers and during the deposition of the HIPIMS layers a shorter and a longer impulse duration are used alternately.

3. Method according to one of the preceding claims, **characterized in that** the impulse length is varied at least once continuously.

4. Method according to one of the preceding claims, **characterized in that** the height of the power pulse is varied.

5. Method according to claim 4 **characterized in that** such a low height of the power pulse is chosen at times that it yields layer areas with a columnar growth typical for DC-MS.

6. Method according to one of the preceding claims, **characterized in that** the power density does not exceed 2000W/cm².

7. Method according to one of the preceding claims 3 to 6, **characterized in that** the at least one continuous variation of the impulse length is executed in such a way that the transition between the layers of different morphology is a gradual transition.

## Revendications

1. Procédé de déposer des systèmes de couches PVD (dépôt physique en phase vapeur) de la phase gazeuse au moyen de pulvérisation sur du moins un substrat, le système de couches comprenant du moins une première et une deuxième couche HIPIMS (pulvérisation cathodique magnétron pulsés à haute puissance) qui sont déposées au moyen d'un procédé HIPIMS qui permet d'actionner du moins deux cathodes partielles de telle manière que pour le dépôt de couches HIPIMS des densités de puissance de 250 W/cm² ou plus et des longueurs d'impulsion ayant une durée d'impulsion de 5ms ou plus sont utilisées, tandis qu'une polarisation est appliquée au substrat,
**caractérisé en ce que** la première ou la deuxième couche HIPIMS est déposée dans une étape du procédé HIPIMS où une densité de puissance de du moins 250W/cm² est utilisée,
une longueur d'impulsion d'une durée d'au moins 5ms étant appliquée, tandis qu'une polarisation est appliquée au substrat et pour le dépôt de l'autre couche HIPIMS, le cas échéant de la deuxième ou de la première couche HIPIMS, une longueur d'impulsion ayant une durée d'impulsion plus courte étant appliquée de telle manière que la morphologie résultante de la première couche HIPIMS diffère de la morphologie de la deuxième couche HIPIMS et la morphologie d'une couche HIPIMS déposée pendant une durée d'impulsion plus longue a des grains plus gros que la morphologie d'une couche HIPIMS déposée pendant une durée d'impulsion plus courte.

2. Procédé selon l'une des revendications précédentes **caractérisé en ce que** le système de couches comprend plus de deux couches HIPIMS et pendant le dépôt des couches HIPIMS une durée d'impulsion plus courte et une durée d'impulsion plus longue sont appliquées en alternance.

3. Procédé selon l'une des revendications précédentes **caractérisé en ce que** la longueur d'impulsion est variée du moins une fois continuellement.

4. Procédé selon l'une des revendications précédentes **caractérisé en ce que** la hauteur de l'impulsion de puissance est variée.

5. Procédé selon la revendication 4 **caractérisé en ce que** temporairement une hauteur de l'impulsion de puissance tellement petite est choisie que des régions de couches ayant une croissance columnaire typique de DC-MS se produisent.

6. Procédé selon l'une des revendications précédentes **caractérisé en ce que** la densité de puissance ne dépasse pas 2000 W/cm².

7. Procédé selon l'une des revendications précédentes 3 à 6 **caractérisé en ce que** la du moins une variation continue de la longueur d'impulsion est exécutée de telle manière que la transition entre les couches de morphologie différente est une transition graduelle.
